# EUROPEAN PATENT SPECIFICATION

(11) **EP 0 720 284 B1**
(45) Date of publication and mention of the grant of the patent: **09.02.2000**
(21) Application number: 94309652.9
(22) Date of filing: 21.12.1994
(51) Int. Cl.: H03F 1/32

(54) **Feedforward amplifier**
Vorwärtskopplungsverstärker
Amplificateur à contre-réaction de type aval

(43) Date of publication of application: 03.07.1996
(73) Proprietor: NEC Corporation, Minato-ku, Tokyo 108-8001 (JP)
(72) Inventor: Fukuchi, Akio, c/o NEC Corporation, Tokyo 108-01 (JP)
(74) Representative: Abnett, Richard Charles

(56) References cited:
- EP-A- 0 367 457
- EP-A- 0 466 123
- EP-A- 0 557 929

## Description

### BACKGROUND OF THE INVENTION

The present invention relates to a feedforward amplifier and, particularly, to a feedforward amplifier for detecting distortion of an input signal amplified by a feedforward loop and amplifying the input signal while restricting the distortion.

### PRIOR ART

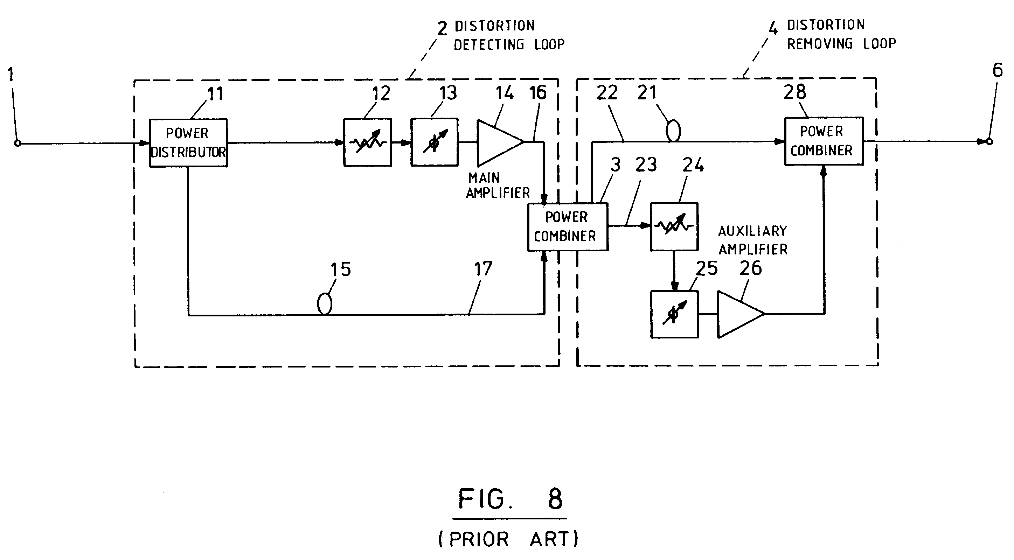

When an input signal including a plurality of frequency-multiplexed carriers is amplified by an amplifier, an intermodulation distortion occurs and is mixed in an output signal of the amplifier. A feedforward amplifier has been known which removes a component of such distortion by means of a feedforward loop. Fig. 8 shows a construction of an example of a conventional feedforward amplifier. In Fig. 8, the feedforward amplifier is constructed such that it amplifies an input signal having frequency in a high frequency band at an input terminal 1 thereof and detects a distortion introduced therein during the amplification by means of a distortion detecting loop 2, removes the distortion by a distortion removing loop 4 after passed through a power combiner circuit 3 and outputs the amplified and distortion removed input at an output terminal 6 thereof.

The distortion detecting loop 2 distributes the input signal through a power distributor 11 to a main signal path 16 composed of a first variable attenuator 12, a first variable phase shifter 13 and a main amplifier 14 arranged in the order and a linear signal path 17 including a first delay line 15. The power combiner 3 outputs a composite signal (difference signal) of signals from the main signal path 16 and the linear signal path 17 and outputs a main amplified signal through the main signal path 16 as it is.

The distortion removing loop 4 includes a main amplifier output signal path 22 including a second delay line 21 and a distortion signal injecting path 23. A second variable attenuator 24, a second variable phase shifter 25 and an auxiliary amplifier 26 are arranged in the distortion signal injecting path 23 and the signals passed through the main amplifier output signal path 22 and the distortion signal injecting path 23 are combined by a power combiner 28. The power distributor 11 and the power combiners 3 and 28 have simple constructions including, for example, transformer circuits, hybrid circuits and directional couplers, etc., respectively.

Describing an operation of this conventional feedforward amplifier, the high frequency band input signal input to the input terminal 1 is branched to 2 channels by the power distributor 11. The high frequency band input signal in one of the channels is amplified through the main signal path 16 including the first variable attenuator 12, the first variable phase shifter 13 and the main amplifier 14. The input signal in the other channel is delayed by a first delay line 15 of the linear signal path 17. The output signals of the main signal path 16 and the linear signal path 17 are supplied to the power combiner 3. Since the first delay line 15 of the linear signal line 17 and the first variable attenuator 12, the first variable phase shifter 13 and the main amplifier 15 of the main signal path 16 are regulated such that the two signals at the input terminal of the power combiner 3 become the same in amplitude and delay amount and opposite in phase, an output of the power combiner 3 is a difference signal therebetween.

The linear signal path 17 includes only the first delay line 15 and therefore there is no distortion produced. Consequently, distortion mixed in the input signal amplified by the first variable attenuator 12, the first variable phase shifter 13 and the main amplifier 14 of the main amplifying signal path 16 or generated in, particularly, the main amplifier 14 can be obtained as the difference error, if the operation of the distortion detecting loop 2 is appropriate. This distortion, that is, the difference signal, is output from a second output terminal of the power combiner 3 to the distortion signal injecting path 23 and the output signal of the main amplifier 14, which is the input signal amplified and containing the distortion, is directly supplied from a first output terminal of the power combiner 3 to the main amplifier output signal path 22.

Transfer functions of the two paths 22 and 23 extending from the input terminals of the power combiner 3 on the side of the path 16 to the output terminal of the power combiner 28 are regulated such that they are the same for amplitude and delay and opposite for phase. Therefore, in the power combiner 28, the distortion passed through the distortion signal injecting path 23 is added in opposite phase to the amplified signal passed through the main amplifier output signal path 22 and having the same amplitude as and an opposite phase to those of the distortion. Thus, the distortion of the amplified signal at the output terminal 6 of the power combiner 28 is cancelled out.

However, in the conventional feedforward amplifier mentioned above, it is very difficult to maintain a balance between the two feedforward loops 2 and 4 stably in time measure since characteristics of the amplifier is degraded by variation of environmental temperature, etc.

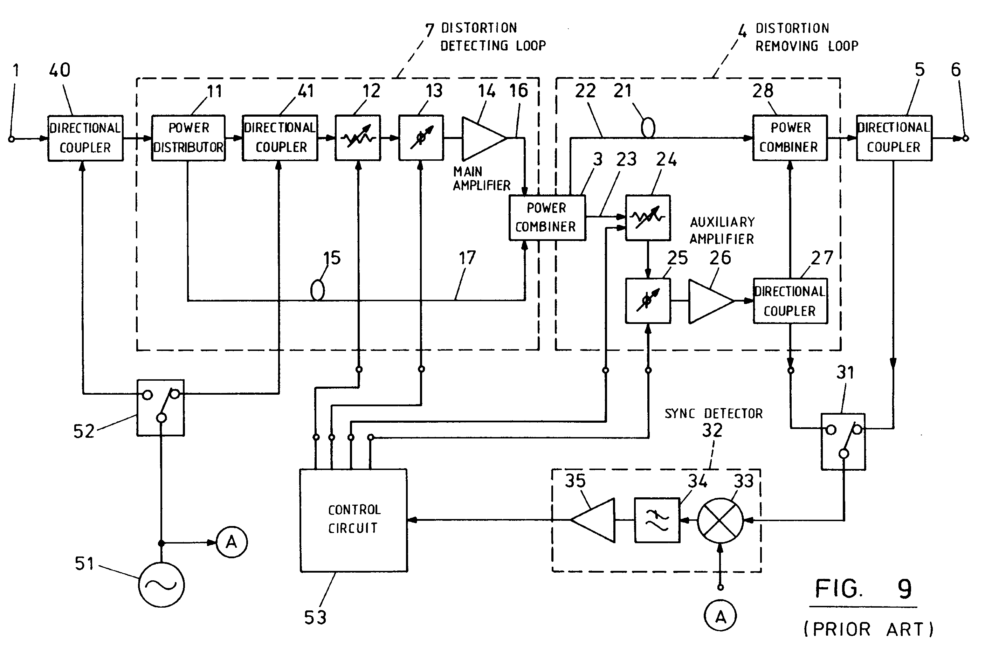

For example, Japanese Patent Application Laid-open No. 1-198809 (published August 10, 1989) discloses a feedforward amplifier which is provided with means for injecting a pilot signal having specific frequency to a distortion detecting loop for the purpose of allowing the feedforward amplifier to operate stably. Fig. 9 shows a construction of an example of the disclosed feedforward amplifier.

In Fig. 9 in which the same constitutional components as those shown in Fig. 8 are depicted by the same reference numerals without detailed description thereof, an input signal supplied to an input terminal 1 is supplied to a distortion detecting loop 7 through a first directional coupler 40 and, after it is amplified and its distortion component is detected by the distortion detecting loop 7, supplied to a distortion removing loop 4 through a power combiner 3.

The distortion detecting loop 7 includes a main amplifier signal path 16 including a power distributor 11, a second directional coupler 41, a first variable attenuator 12, a first variable phase shifter 13 and a main amplifier 16 and a linear signal path 17. The distortion removing loop 4 includes a linear signal path 22 and a distortion signal injecting path 23 including a second variable attenuator 24, a second variable phase shifter 25, an auxiliary amplifier 26 and a third directional coupler 27. An output terminal of a power combiner 28 is connected to an output terminal 6 through a fourth directional coupler 5. An oscillator 51 outputs a pilot signal having a specific frequency which is input to the first directional coupler 40 or the second directional coupler 41 through a turn-over switch 52 and to a mixer 33 of a sync detection circuit 32 including the mixer, a low-pass filter 34 and a d.c. amplifier 35.

A high frequency turn-over switch 31 functions to select one of outputs of the directional couplers 5 and 27. The mixer 33 of the sync detection circuit 32 performs a frequency conversion of the constant frequency from an oscillator 51 with the output signal of the high frequency turn-over switch 31. A control circuit 53 controls the first variable attenuator 12 and the first variable phase shifter 13 or the second variable attenuator 25 and the second variable phase shifter 26 on the basis of the output of the sync detection circuit 32.

In this feedforward amplifier, when the distortion detecting loop is to be controlled, the turn-over switches 52 and 31 are switched to positions opposite to those shown in Fig. 9 so that the pilot signal is input to the first directional coupler 40 through the switch 52 and a signal from the auxiliary amplifier 26 to the sync detection circuit 32 through the third directional coupler 27 and the switch 31. Thus, the control circuit 53 controls attenuation amount of the first variable attenuator 12 and phase shift of the first variable phase shifter 13 such that a level of the pilot signal in the output signal of the auxiliary amplifier 26 becomes minimum. Thus, it is possible to minimize distortion component due to unbalanced operation of the distortion detecting loop 7.

On the other hand, when the switches 52 and 31 are positioned as shown in Fig. 9, the pilot signal from the oscillator 51 is input to the main amplifier signal path 16 and a signal branched by the directional coupler 5 from the output signal of the power combiner 28 is input to the sync detection circuit 32 through the switch 31. Therefore, the control circuit 53 controls the second variable attenuator 24 and the second variable phase shifter 25 such that the level of the pilot signal contained in the output signal of the power combiner 28 becomes minimum. As a result, an automatic regulation of the distortion removing loop 4 becomes possible.

By executing the above mentioned controls of the distortion detecting loop 7 and the distortion removing loop 4 continuously or intermittently, an optimum operating condition of the feedforward amplifier is realized. The signal input to the input terminal of this feedforward amplifier is modulated for information transmission and may be discontinuous in some case. Therefore, the operation becomes unstable if this input signal is used for the control. However, since this feedforward amplifier performs the control by using the pilot signal whose level and frequency are constant, a stable control is possible.

Nevertheless, the feedforward amplifier using the pilot signal has a problem that, when the frequency of the pilot signal is set within an operating frequency band, the control becomes unstable if there is an input signal whose frequency is identical to that of the pilot signal.

On the other hand, when the frequency of the pilot signal is set out side of the operating frequency range, the characteristics of the constitutional components of the paths 16 and 17 of the distortion detecting loop 7 or the paths 22 and 23 of the distortion removing loop 4 must be coincident in a wide frequency range including the pilot signal frequency. For example, in order to obtain a compression amount of 30 dB or more in the frequency range, deviations of amplitude and phase must be within ± 0.3 dB and ± 2°, respectively. These values correspond to a deviation between the pilot signal frequency and the operating frequency when the pilot signal is completely cancelled out. Therefore, it is desirable to set the pilot signal frequency as close to the operating frequency as possible.

Further, the characteristics of the constitutional components of the respective loops 7 and 4, such as the main amplifier 14 and the auxiliary amplifier 26, etc., vary with variation of ambient temperature, etc. In order to follow such variation, it is necessary to control the distortion detecting loop 7 and the distortion removing loop 4 as frequently as possible. However, when the control of the distortion detecting loop 7 is performed, the pilot signal may leak externally though an amount of leakage may be small.

Further, when the pilot signal is to be cancelled by, for example, 40 dB, isolation required in the high frequency switches 52 and 31 must be 40 dB or more. Unfortunately, a semiconductor switch capable of realizing the isolation of as large as 40 dB which is frequently used in the feedforward amplifier operating around 1 GHz is still not practical and, therefore, mechanical high frequency switches whose life is generally shorter than that of a semiconductor switch must be used as the switches 52 and 31.

EP-A-0466123 (NIPPON TELEGRAPH AND TELEPHONE CORPORATION) describes a feedforward amplifier which has an error detection circuit for detecting a nonlinear distortion component of a main amplifier, and an error rejection circuit for amplifying the detected distortion component by an auxiliary amplifier and injecting it into the main amplifier, thereby to cancel an error component. A first pilot signal is injected into a signal input path of the feedforward amplifier, the first pilot signal having a frequency which is set a little apart from the frequency band of the input signal or which is frequency spread.

### SUMMARY OF THE INVENTION

The invention is defined in claim 1 below to which reference should now be made. Advantageous features of the invention are set forth in the appendant claims.

A preferred embodiment of the invention is described in detail below, in the form of a feedforward amplifier including a distortion detecting loop having a main amplifier amplifying an input signal, a first variable attenuator (12) and a first variable phase shifter in the main amplifier's signal path,
a power combiner coupled to said distortion detecting loop deriving an amplified signal and a distortion contained in the amplified signal;
a distortion removing loop receiving said amplified signal and the distortion, having an auxiliary amplifier, a second variable attenuator and a second variable phase shifter in the auxiliary amplifier's signal path, cancelling out the distortion from the amplified signal derived from said power combiner;
a variable frequency oscillator for outputting a pilot signal;
sync detection means receiving a distortion component derived from a portion of said distortion removing loop or the amplified signal whose distortion is cancelled by said distortion removing loop, detecting a signal level;
first control means setting the frequency of said pilot signal;
second control means controlling said first variable attenuator and first variable phase shifter on the basis of the signal level of said distortion component received by said sync detection means when the pilot signal is input to said distortion detecting loop together with the input signal; and third control means controlling said second variable attenuator and second variable phase shifter on the basis of the signal level of the amplified signal whose distortion is cancelled out received by said sync detection means when said pilot signal is supplied to the signal path of said main amplifier in said distortion detecting loop
   characterized in that
said first control means controls said variable frequency oscillator by means of a feedback control loop with the sync detection means such that the pilot signal frequency is in a frequency band designated to the input signal and other than the frequencies of the input signal and the distortion.

In the present construction as mentioned above, the first control circuit sets the frequency of the pilot signal from the variable frequency oscillator to a value other than the frequencies of the input signal and the distortion and close to an average value of the frequency of the input signal. Therefore, the frequency of the input signal to the distortion detecting loop, which is to be amplified thereby, never become identical to that of the pilot signal and the pilot signal frequency can be set as close to the input signal frequency to be amplified as possible.

Further, in a preferred embodiment the fourth control circuit controls the distortion detecting and removing loops such that the control of the distortion removing loop is performed normally by the third control circuit and the control of the distortion detecting loop is performed by the second control circuit when environmental condition is changed largely. Therefore, the control time of the distortion detecting loop can be minimized.

### BRIEF DESCRIPTION OF THE DRAWINGS

Fig. 1 shows a construction of an embodiment of a feedforward amplifier according to the present invention;
Fig. 2 is a flowchart of an operation of the embodiment shown in Fig. 1;
Fig. 3 is a flowchart of a first step of the operation shown in Fig. 2;
Fig. 4 is a flowchart of a second step of the operation shown in Fig. 2;
Fig. 5 is a flowchart of a third step of the operation shown in Fig. 2;
Fig. 6 is a flowchart of a fourth step of the operation shown in Fig. 2;
Fig. 7 is a flowchart of a re-control operation of a distortion detecting loop of the embodiment shown in Fig. 1;
Fig. 8 is a construction of an example of a conventional feedforward amplifier; and
Fig. 9 is a construction of another example of the conventional feedforward amplifier.

### DETAILED DESCRIPTION OF THE PREFERRED EMBODIMENTS

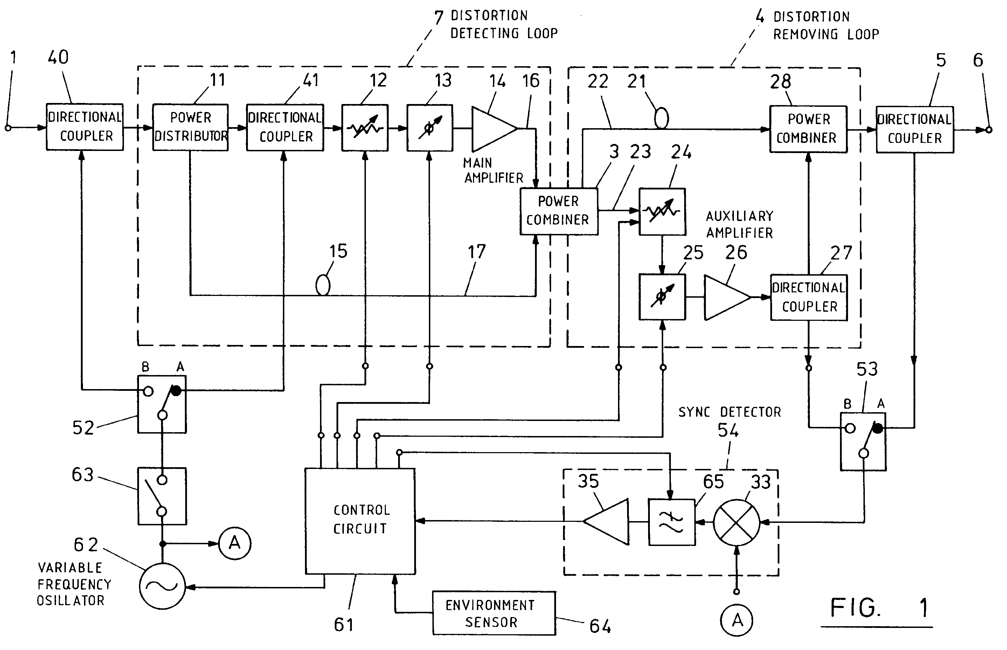

Fig. 1 shows a construction of an embodiment of a feedforward amplifier according to the present invention. In Fig. 1, the same components as those shown in Fig. 9 are depicted by the same reference numerals without detailed explanation thereof. In Fig. 1, a control circuit 61 controls attenuation of a first variable attenuator 12 and phase shift of a first variable phase shifter 13 of a distortion detecting loop 7, attenuation of a second variable attenuator 24 and phase shift of a second variable phase shifter 25, a cut-off frequency of a variable low-pass filter 65 of a sync detection circuit 54 and an oscillation frequency of a variable frequency oscillator 62. The variable frequency oscillator 62 is a voltage-controlled oscillator whose output frequency is variably controlled by an output voltage of the control circuit 61 and is used as a pilot signal.

A high frequency switch 63 is an on/off switch controlled by the control circuit 61 and functions to pass the output signal (the pilot signal) of the variable frequency oscillator 62 to a high frequency switch 52 or cut out the output signal passage to the latter high frequency switch. An environment sensor 64 detects environmental conditions such as ambient temperature and outputs an electric signal having a level corresponding to the conditions. The high frequency switch 53 for selecting one of the output signals of the directional couplers 5 and 27 and supplies it to the mixer 33 of the sync detection circuit 54 and the high frequency switch 52 are ON/OFF controlled by the switching signal from the control circuit 61 similarly to the high frequency switch 63.

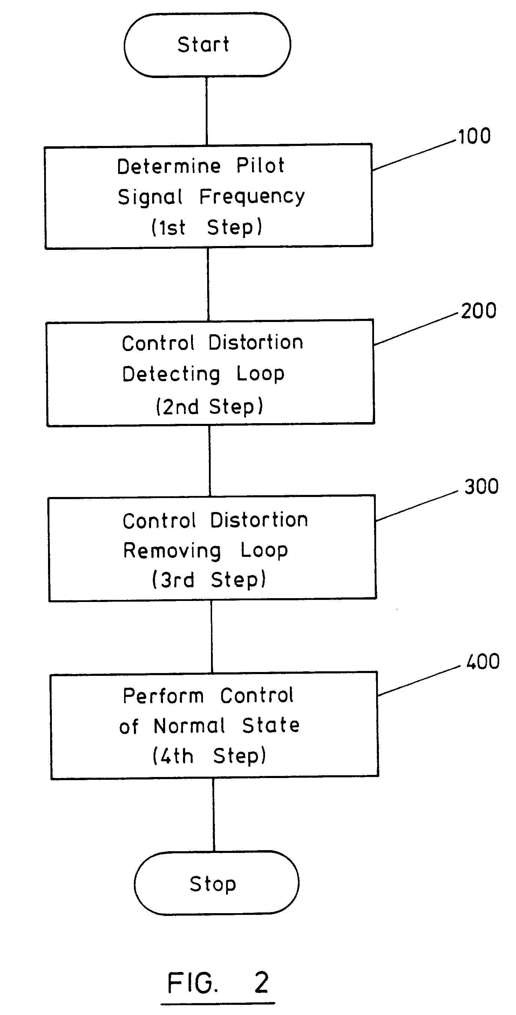

The operation of this embodiment will be described. In the feedforward amplifier of this embodiment, the operation including four steps is performed in the sequence shown in Fig. 2 under the control of the control circuit 61. That is, in the first step, the frequency of the pilot signal is determined (step 100), then, in the second step, the distortion detecting loop 7 is controlled (step 200), then, in the third step, the distortion removing loop 4 is controlled (step 300) and, finally, in the fourth step, the normal state control is performed (step 400). The operations in the respective steps will be described in more detail.

### (1) First Step (100)

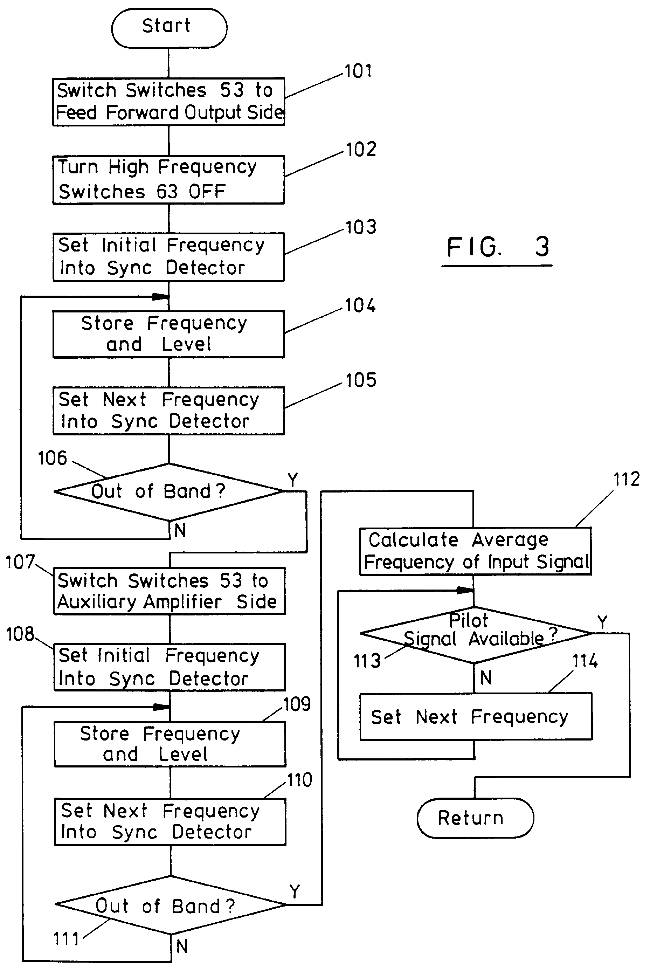

The determination of pilot signal frequency in the first step is performed according to the flowchart shown in Fig. 3. First, the switch 53 shown in Fig. 1 is connected to a terminal A such that the output signal of the feedforward amplifier is input through the fourth directional coupler 5 and the switch 53 to the sync detection circuit 54 (step 101). Then, the high frequency switch 63 is turned OFF (step 102) such that the pilot signal is not input to the distortion detecting loop 7. Thus, only the input signal from the input terminal 1 is allowed to pass to the power distributor 11 through the first directional coupler 40 in which it is divided to two signals one of which is input to the main amplifier 14 through the second directional coupler 41, the first variable attenuator 12 and the first variable phase shifter 13 and the other of which is input to the power combiner 3 after delayed by the first delay line 15. The input signal is, for example, a signal obtained by time-division multiplexed 5 carriers having identical amplitude and the feedforward amplifier linearly amplifies these 5 carriers simultaneously.

As described previously, the power combiner 3 not only outputs the output signal of the main amplifier 14 directly from the first output terminal to the main amplifier signal path 22 of the distortion removing loop 4 but also combines the output of the main amplifier 14 from the second output terminal with the input signal from the delay line 15, derives distortion mixed in or generated by the constitutional components of the path 16 and outputs it to the distortion signal injecting path 23 of the distortion removing loop 4. The distortion removing loop 4 cancels out the distortion input to the distortion signal injecting path 23 in the similar manner to that in the conventional feedforward amplifier and outputs the amplified and distortion-restricted signal from the power combiner 28 through the fourth directional coupler 5 to the output terminal 6 and the switch 53 as the output signal of the feedforward amplifier.

In this case, the control circuit 61 controls the output oscillation frequency (pilot signal frequency) of the variable frequency oscillator 62 to a certain frequency so that the sync detection circuit 54 performs a sync detection at the frequency (step 103). Then, the control circuit 61 stores the frequency and level of the output signal of the feedforward amplifier synchronously detected by the sync detection circuit 54 (step 104). Then, the control circuit 61 changes the output oscillation frequency of the variable frequency oscillator 62 to another value such that the sync detection circuit 54 operates on the new frequency (step 105) and determines whether or not the new frequency is within the predetermined available frequency range (step 106). If it is within the predetermined available frequency range, the control circuit 61 re-stores the frequency and level of the output signal of the feedforward amplifier synchronously detected in the step 104.

In this manner, the control circuit 61 stores the frequency and level of the output signal of the feedforward amplifier while sequentially changing the sync detection frequency of the sync detection circuit 54 within the available frequency range by controlling the output frequency of the variable frequency oscillator 62 (steps 109 to 111).

Thus, the frequency of the intermodulation distortion between the 5 carriers which is generated in amplifying the input signal by the main amplifier 14. In a case where the control circuit 61 is capable of computing frequency component of distortion generated by the frequency and level of the input signal, there is no need of performing the processing in the steps 109 to 111.

Thereafter, the control circuit 61 calculates an average value of the frequencies (in this embodiment, 5 carrier frequencies) of the input signal stored in the step 104 (step 112) and then the pilot signal frequency is determined in steps 113 and 114. That is, it is impossible to perform a stable high speed control if the pilot signal frequency is coincident with the frequency of the input signal or the distortion frequency generated due to the presence of the input signal and highly precise frequency characteristics of the two loops 7 and 4 are required if the pilot signal frequency differs considerably from the input signal frequency.

In view of this fact, in this embodiment, the pilot signal frequency is set to a value which is neither the input signal frequency stored in the step 104 nor the distortion frequency generated by the input signal stored in the step 109 but around the average value of the input signal frequencies calculated in the step 112 (steps 113 and 114).

Alternatively, in a case where the number of carriers of the input signal is not so many and the carrier frequencies of the input signal are predictable, it may be possible to select a suitable frequency without scanning the sync detection frequency in the sync detection circuit 54 and then to confirm if it is coincident with neither the input signal frequency nor the distortion frequency by switching the switch 53 between the terminals A and B.

### (2) Second Step (200)

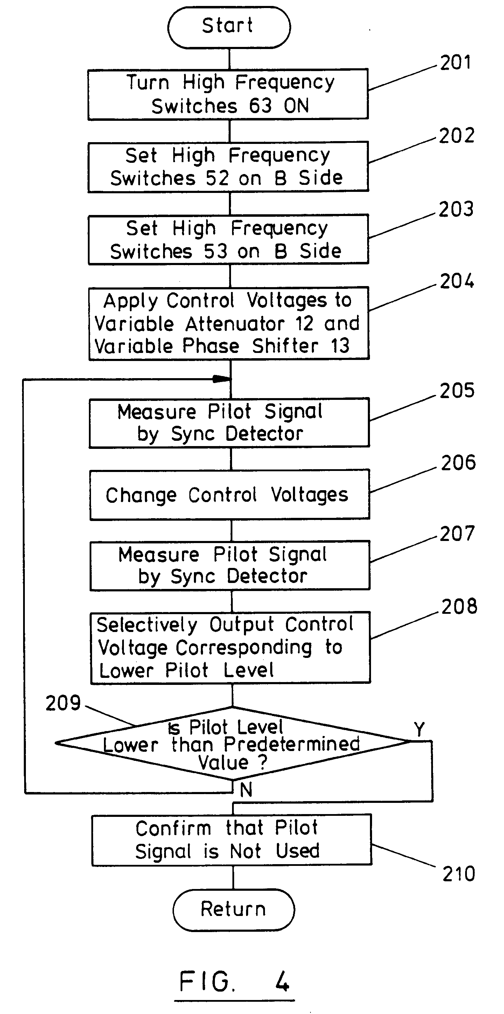

The control of the distortion detecting loop 7 is performed according to the flowchart shown in Fig. 4. First, the high frequency switch 63 shown in Fig. 1 is turned ON (step 201) and then the high frequency switches 52 and 53 are connected to the terminals B (steps 202 and 203). With this procedure, the pilot signal generated by the variable frequency oscillator 62 and having frequency determined in the First Step is supplied through the high frequency switch 63, the switch 52 and the first directional coupler 40 to the distortion detecting loop 7 and the output distortion component of the auxiliary amplifier 26 is supplied through the third directional coupler 27 and the switch 53 to the sync detection circuit 54. In this case, it is possible to improve signal to noise ratio (S/N ratio) of the sync detection circuit 54 by controlling the cut-off frequency of the variable low-pass filter 65 contained in the sync detection circuit 54 by the control circuit 61 so that the pass band of the sync detection circuit 54 is narrowed.

Then, the control circuit 61 applies suitable control voltages to the variable attenuator 12 and the variable phase shifter 13 (step 204) and, after the detection level of the sync detection circuit 54, that is, the level of the pilot signal, at that time is measured (step 205), the control voltages are changed to other values (step 206) and the detection level of the pilot signal of the sync detection circuit 54 is measured again (step 207).

The pilot signal level sync detected by the sync detection circuit 54 at that time is the distortion level indicative of an error between signals in the paths 16 and 17 of the distortion detecting loop 7 which are equal in amplitude and opposite in phase. Therefore, the control circuit 61 controls the variable attenuator 12 and the variable phase shifter 13 with control voltages with which a low detection level among the detection levels of the measured pilot signal is obtained (step 208).

Then, the control circuit 61 decides whether or not the detection level of the pilot signal at that time is lower than a predetermined value (step 209) and, if it is higher, the process is returned to the step 205. In this manner, the control circuit 61 controls the amount of attenuation of the variable attenuator 12 and the amount of phase shift of the variable phase shifter 13 such that the level of the pilot signal detected by the sync detection circuit 54 and input to the control circuit 61 becomes a minimum value smaller than the predetermined value. The control method in this case is preferably based on an algorithm having high converging speed, such as the steepest descent method.

Thereafter, the control circuit 61 confirms that the pilot signal frequency is coincident with neither the input signal frequency at the input terminal 1 nor the distortion frequency generated by this input signal by turning the high frequency switch 63 OFF (step 210).

### (3) Third Step (300)

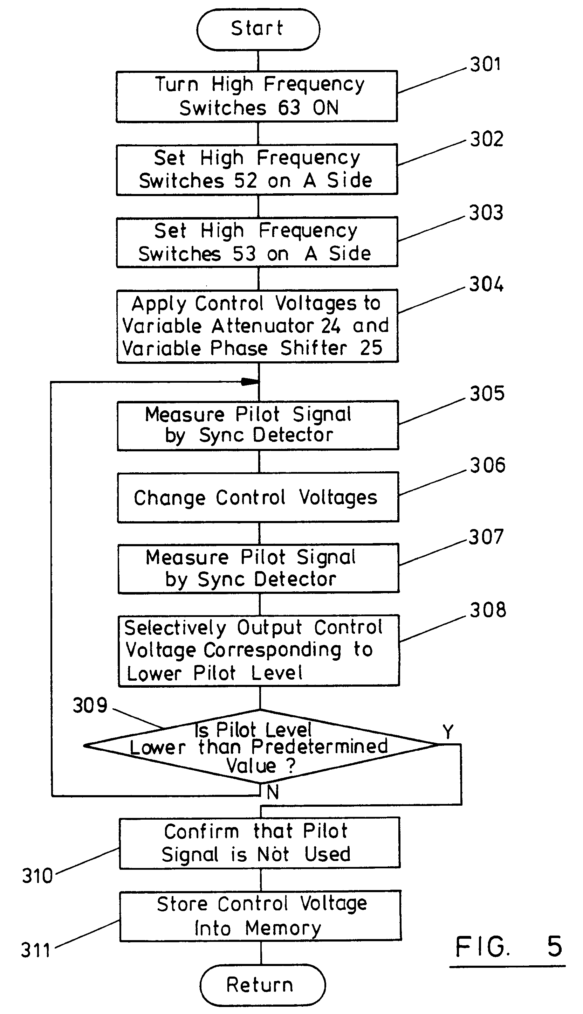

The control of the distortion removing loop 4 is performed according to the flowchart shown in Fig. 5. First, the high frequency switch 63 shown in Fig. 1 is turned ON (step 301) and then the high frequency switches 52 and 53 are connected to the terminals A (steps 302 and 303). With this procedure, the pilot signal generated by the variable frequency oscillator 62 and having frequency determined in the First Step is supplied through the high frequency switch 63, the switch 52 and the second directional coupler 41 to the path 16 of the distortion detecting loop 7 and the output signal of the distortion removing loop 4 is supplied through the fourth directional coupler 5 and the switch 53 to the sync detection circuit 54.

Then, the control circuit 61 applies initial values of the control voltages to the variable attenuator 24 and the variable phase shifter 25 (step 304) and, after the detection level of the sync detection circuit 54, that is, the level of the pilot signal, at that time is measured (step 305), the control voltages are changed to other values (step 306) and the detection level of the pilot signal of the sync detection circuit 54 is measured again (step 307).

The pilot signal level sync detected by the sync detection circuit 54 at that time is the distortion level indicative of an error between signals in the paths 22 and 23 of the distortion removing loop 4 which are equal in amplitude and opposite in phase. Therefore, the control circuit 61 controls the variable attenuator 24 and the variable phase shifter 25 with control voltages with which a low detection level among the detection levels of the measured pilot signal is obtained (step 308).

Then, the control circuit 61 decides whether or not the detection level of the pilot signal at that time is lower than a predetermined value (step 309) and, if it is higher, the process is returned to the step 305. In this manner, the control circuit 61 controls the amount of attenuation of the variable attenuator 24 and the amount of phase shift of the variable phase shifter 25 such that the level of the pilot signal detected by the sync detection circuit 54 and input to the control circuit 61 becomes a minimum value smaller than the predetermined value.

Thereafter, the control circuit 61 confirms that the pilot signal frequency is coincident with neither the input signal frequency at the input terminal 1 nor the distortion frequency generated by this input signal by turning the high frequency switch 63 OFF (step 310). Then, the control circuit 61 stores the control voltages of the variable attenuator 24 and the variable phase shifter 25 and the output voltage of the environment sensor 64 at this time point in the built-in memory (step 311).

### (4) Fourth Step (400)

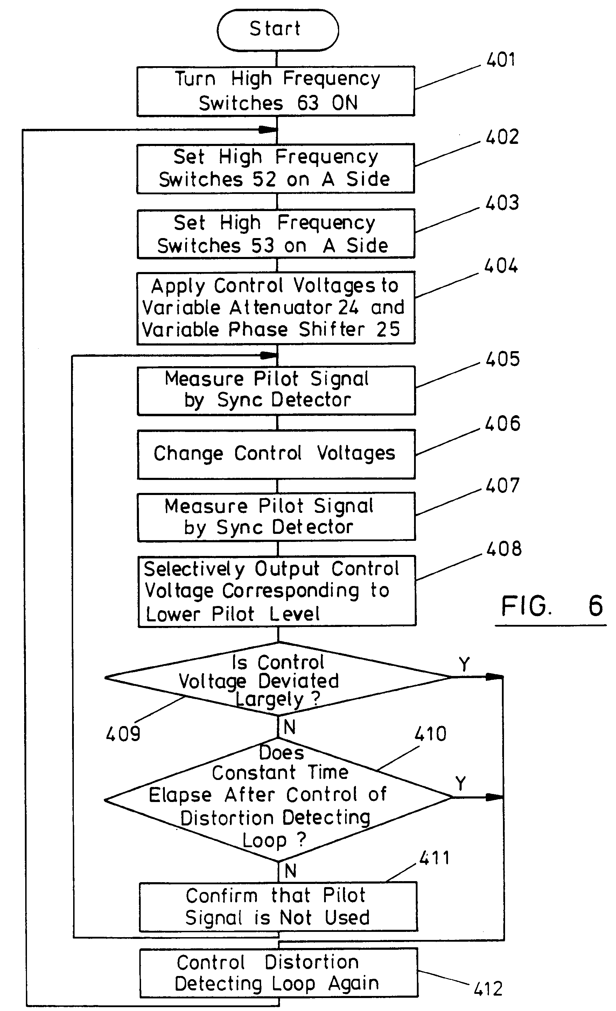

The control in the normal state in the Fourth Step is performed according to the flowchart shown in Fig. 6. It should be noted that, at the end of control in the Third Step, the optimum operation of the feedforward amplifier is realized. However, the control must follow variations of gain and phase of the amplifier due to variation of environment condition, such as ambient temperature, from time to time.

Further, although the attenuation of the distortion removing loop 4 directly determines the attenuation of distortion, the attenuation of the input signal by the distortion detecting loop 7 is to prevent the level of the input signal leaked to the auxiliary amplifier 26 from becoming too high. Therefore, when there is some margin in the output of the auxiliary amplifier 26, the amount of attenuation of the distortion removing loop 4 becomes flexible correspondingly. Further, when the distortion detecting loop 7 is controlled, the pilot signal leaks externally.

According to this embodiment, the control of the distortion removing loop 4 is performed in the normal state, as the Fourth Step control. Since, in usual, there is almost no case where the control voltages are largely changed in the normal state, it is preferable to use a control method in which respective control voltages are changed slightly. Therefore, in the Fourth Step, after the control circuit 61 controls the amount of attenuation of the variable attenuator 24 and the amount of phase shift of the variable phase shifter 25 with the control voltages for the lower detection level of the pilot signal detected by the sync detection circuit 54 and input to the control circuit 61 through steps 401 to 408 similar to the control steps 301 to 308 of the distortion removing loop 4 in the Third Step, the control circuit 61 determines whether or not the control voltages are largely deviated from the predetermined values (step 409).

If there is no large deviation, the control circuit 61 determines whether or not a constant time lapses after the previous control of the distortion detecting loop 7 (step 410). If the constant time is not lapsed, it is confirmed by turning the high frequency switch 63 OFF whether or not the pilot signal frequency is coincident with neither the input signal frequency nor the distortion frequency caused by the input signal (step 411). Then, the process is returned to the step 405 to obtain the control voltages with which a lower detection level of the pilot signal is obtained, by changing the control voltages.

On the other hand, if it is decided in the step 409 that the control voltages are deviated largely, it is assumed that the large deviation of the control voltages of the distortion removing loop 4 is due to large environmental change since the distortion detecting loop 7 and the distortion removing loop 4 are thought as being under substantially the same environmental condition and the distortion removing loop 4 is thought as being always controlled to the optimum value. Therefore, the control circuit 61 decides this as the necessity of control of the distortion detecting loop 7 and after it controls the distortion detecting loop 7 again (step 412), it returns to the step 402 to control the distortion removing loop 4 in the normal state again.

Further, since the respective constitutional components of the feedforward amplifier are subjected to age variation, it is necessary to activate the distortion detecting loop 7 at a relatively long time interval. Therefore, when it is decided in the step 410 that the constant time is lapsed from the previous control of the distortion detecting loop 7, the control circuit 61 decides also that a control of the distortion detecting loop 7 is necessary and, after it controls the distortion detecting loop 7 again (step 412), it is returned to the step 402 to control the distortion removing loop 4 in the normal state.

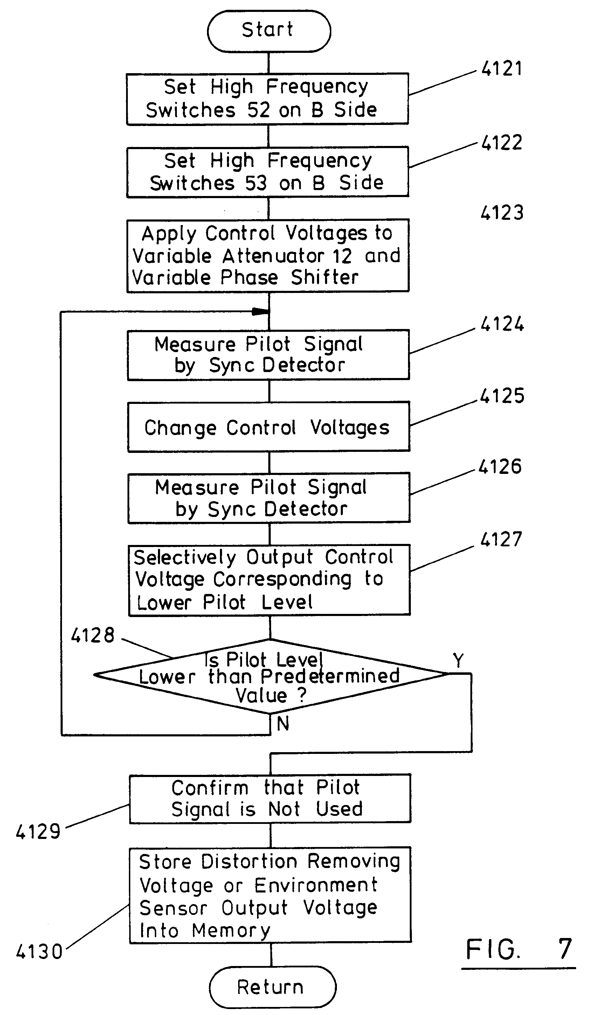

The re-control of the distortion detecting loop 7 in the step 412 is performed according to the flowchart shown in Fig. 7. This re-control is similar to the control of the distortion detecting loop 7 in the Second Step described with respect to Fig. 4. After the control circuit 61 connects the high frequency switches 52 and 53 to the terminals B (steps 4121 and 4122), the control circuit 61 controls the amount of attenuation of the variable attenuator 12 and the amount of phase shift of the variable phase shifter 13 such that the level of the pilot signal detected by the sync detection circuit 54 and input to the control circuit 61 becomes a minimum value smaller than the predetermined value (steps 4123 to 4128).

Thereafter, it is confirmed by turning the high frequency switch 63 OFF that the pilot signal frequency is coincident with neither the input signal frequency nor the distortion frequency caused by the input signal (step 4129). Then, at a time when the control of the distortion detecting loop 7 is completed, the distortion removing control voltages for the variable attenuator 24 and the variable phase shifter 25 and the output voltage of the environment sensor 64 are updated and stored in the memory in the control circuit 61 (step 4130).

It is possible in the step 409 shown in Fig. 6 to compare the output voltage of the environment sensor 64 stored in the Third Step with the current output voltage of the environment sensor 64 to decide whether or not the current voltage is changed largely from the predetermined value and, if it is changed largely, the distortion detecting loop 7 is controlled again.

According to this embodiment, it is possible to constitute the feedforward amplifier which can be stably controlled by performing the First to Fourth Steps sequentially, which includes constitutional components having frequency characteristics not as precise as required in the conventional feedforward amplifier and which is durable for a long time due to the reduced number of controls of the distortion detecting loop.

As described hereinbefore with reference to the preferred embodiment, the pilot signal frequency is never coincident with the frequency of the input signal input to the distortion detecting loop and therefore it is possible to control the feedforward amplifier stably. Further, since the pilot signal frequency can be set around the frequency of the input signal to be amplified and the frequency characteristics of one of the two paths in the distortion detecting loop is not required as precisely coincident with that of the other and this is also true for the distortion removing loop, the feedforward amplifier can be easily constructed.

Further, since the control time of the distortion detecting loop can be made short by the Fourth step, the external leakage of the pilot signal is minimized. Further, since the frequency of switching the control between the distortion detecting loop and the distortion removing loop is lower than that in the conventional feedforward amplifier, it is possible to construct the feedforward amplifier having longer life compared with the conventional amplifier even if mechanical high frequency switches are used.

## Claims

1. A feedforward amplifier including a distortion detecting loop (7) having a main amplifier (14) amplifying an input signal, a first variable attenuator (12) and a first variable phase shifter (13) in the main amplifier's signal path (16);
a power combiner (3) coupled to said distortion detecting loop deriving an amplified signal and a distortion contained in the amplified signal;
a distortion removing loop (4) receiving said amplified signal and the distortion, having an auxiliary amplifier (26), a second variable attenuator (24) and a second variable phase shifter (25) in the auxiliary amplifier's signal path, cancelling out the distortion from the amplified signal derived from said power combiner;
a variable frequency oscillator (62) for outputting a pilot signal;
sync detection means (54) receiving a distortion component derived from a portion of said distortion removing loop or the amplified signal whose distortion is cancelled by said distortion removing loop, said sync detection means detecting a signal level;
first control means (61) setting the frequency of said pilot signal;
second control means (61) controlling said first variable attenuator and first variable phase shifter on the basis of the signal level of said distortion component received by said sync detection means when the pilot signal is input to said distortion detecting loop together with the input signal (52,53:B); and
third control means (61) controlling said second variable attenuator and second variable phase shifter on the basis of the signal level of the amplified signal whose distortion is cancelled out received by said sync detection means when said pilot signal is supplied to the signal path of said main amplifier in said distortion detecting loop (52,53:A);
characterized in that
said first control means controls said variable frequency oscillator by means of a feedback control loop with the sync detection means such that the pilot signal frequency is in a frequency band designated to the input signal and other than the frequencies of the input signal and the distortion.

2. A feedforward amplifier as claimed in claim 1, wherein said first control means controls the pilot signal frequency to become close to an average value of the frequency of the input signal.

3. The feedforward amplifier claimed in claim 1 or claim 2, further comprising an environment sensor (64) for outputting a signal having a level corresponding to a detected environmental state and fourth control means (61) for succeeding the control of said distortion removing loop by said third control means in a normal state after execution of control by said first to third control means and executing the control of said distortion detecting loop (412) by said second control means again when there is a change in the output signal of said environment sensor exceeding a predetermined value (409).

4. The feedforward amplifier claimed in claim 1 or claim 2, further comprising fourth control means (61) for succeeding the control of said distortion removing loop by said third control means in a normal state after execution of control by said first to third control means and executing the control of said distortion detecting loop by said second control means again (412) when there is a change in a control voltage provided to said distortion removing loop exceeding a predetermined value (409).

5. The feedforward amplifier claimed in claim 3 or 4 wherein said fourth control means succeeds the control of said distortion removing loop until a predetermined time lapses after an end of control of said third control means and executes the control of said distortion detecting loop by said second control means again after the predetermined time lapses (410).

## Patentansprüche

1. Vorwärtskoppler mit einem Verzerrungs-Detektorkreis (7) mit einem Hauptverstärker (14) zur Verstärkung eines Eingangssignals, eins ersten Dämpfungsregler (12) und einem ersten variablen Phasenschieber (13) im Signalweg (16) des Hauptverstärkers; einem mit dem Verzerrungs-Detektorkreis verbundenen Leistungs-Kombinator (3) zur Ableitung eines verstärkten Signals und einer in diesem enthaltenen Verzerrung; einem Verzerrungs-Beseitigungskreis (4) zur Aufnahme des verstärkten Signals und der Verzerrung, der einen Hilfsverstärker (26), einen zweiten Dämpfungsregler (24) und einen zweiten variablen Phasenschieber (25) im Signalweg des Hilfsverstärkers aufweist und die Verzerrung von dem vom Leistungs-Kombinator abgeleiteten verstärkten Signal wegnimmt; einem variablen Frequenz-Oszillator (62) zur Ausgabe eines Pilotsignals; einer Synchronisations-Detektoreinrichtung (54) zur Aufnahme einer von einem Teil des Verzerrungs-Beseitigungskreises abgeleiteten Verzerrungskomponente bzw. des verstärkten Signals, dessen Verzerrung durch den Verzerrungs-Beseitigungskreis weggenommen wurde, wobei die Synchronisations-Detektoreinrichtung einen Signalpegel erfasst; einer ersten Steuereinrichtung (61) zur Einstellung der Frequenz des Pilotsignals; einer zweiten Steuereinrichtung (61) zur Steuerung des ersten Dämpfungsreglers und des ersten variablen Phasenschiebers auf der Basis des Signalpegels der Verzerrungskomponente, die von der Synchronisations-Detektoreinrichtung bei Eingabe des Pilotsignals in die Verzerrungs-Detektoreinrichtung zusammen mit dem Eingangssignal (52, 53:B) aufgenommen wird; und einer dritten Steuereinrichtung (61) zur Steuerung des zweiten Dämpfungsreglers und des zweiten variablen Phasenschiebers auf der Basis des Signalpegels des verstärkten Signals, dessen Verzerrung beim Empfang durch die Synchronisations-Detektoreinrichtung beseitigt wurde, bei Zuführung des Pilotsignals zum Signalweg des Hauptverstärkers im Verzerrungs-Detektorkreis (52, 53:A);
dadurch gekennzeichnet, dass
die erste Steuereinrichtung den variablen Frequenz-Oszillator über eine Rückkopplungsschleife mit der Synchronisations-Detektoreinrichtung steuert dergestalt, dass sich die Pilotsignal-Frequenz innerhalb eines dem Eingangssignal zugeordneten Frequenzbandes befindet und sich von den Frequenzen des Eingangssignals und der Verzerrung unterscheidet.

2. Vorwärtskoppler nach Anspruch 1, dadurch gekennzeichnet, dass die erste Steuereinrichtung die Pilotsignal-Frequenz so steuert, dass sie in der Nähe des Mittelwerts der Frequenz des Eingangssignals liegt.

3. Vorwärtskoppler nach Anspruch 1 oder 2, gekennzeichnet durch einen Umgebungs-Sensor (64) zur Ausgabe eines Signals, dessen Pegel einem erfassten Umgebungszustand entspricht; und eine vierte Steuereinrichtung (61), die nach Ausführung der Steuerungsfunktionen durch die erste bis dritte Steuereinrichtung im Normalfall der Steuerung des Verzerrungs-Beseitigungskreises durch die dritte Steuereinrichtung nachgeführt die durch die zweite Steuereinrichtung durchgeführte Steuerung des Verzerrungs-Detektorkreis erneut vornimmt (412), wenn eine über einen Vorgabewert hinausgehende Änoderung des Ausgangssignals vom Umgebungs-Detektor erfolgt (409).

4. Vorwärtskoppler nach Anspruch 1 oder 2, gekennzeichnet durch eine vierte Steuereinrichtung (61), die nach Ausführung der Steuerungsfunktionen durch die erste bis dritte Steuereinrichtung im Normalfall der Steuerung des Verzerrungs-Beseitigungskreises durch die dritte Steuereinrichtung nachgeführt die durch die zweite Steuereinrichtung vorgenommene Steuerung des Verzerrungs-Detektorkreises erneut vornimmt (412), wenn eine über einen Vorgabewert (409) hinausgehende Änderung einer dem Verzerrungs-Beseitigungskreis zugeordneten Steuerspannung erfolgt (409).

5. Vorwärtskoppler nach Anspruch 3 oder 4, dadurch gekennzeichnet, dass die vierte Steuereinrichtung der Steuerung des Verzerrungs-Beseitigungskreises bis zum Ende einer vorgegebenen Zeitspanne nach Beendigung der Steuerung durch die dritte Steuereinrichtung nachfolgt und die durch die zweite Steuereinrichtung durchgeführte Steuerung des Verzerrungs-Detektorkreises nach Ablauf der vorgegebenen Zeitspanne erneut vornimmt (410).

## Revendications

1. Ampllficateur d'action anticipée comprenant une boucle de détection de distorsion (7) comportant un amplificateur principal (14) amplifiant un signal d'entrée, un premier atténuateur variable (12) et un premier déphaseur variable (13) dans le chemin de signal de l'amplificateur principal (16) ;
un mélangeur de puissance (3) couplé à ladite boucle de détection de distorsion déduisant un signal amplifié et une distorsion contenue dans le signal amplifié ;
une boucle d'enlèvement de distorsion (4) recevant ledit signal amplifie et la distorsion, comportant un amplificateur auxiliaire (26), un second atténuateur variable (24) et un second déphaseur variable (25) dans le chemin de signal de l'amplificateur auxiliaire, annulant la distorsion du signal amplifié déduit dudit mélangeur de puissance ;
un oscillateur à fréquence variable (62) pour sortir un signal pilote ;
des moyens de détection de synchronisation (54) recevant une composante de distorsion déduite d'une partie de ladite boucle d'enlèvement de distorsion ou le signal amplifié dont la distorsion est annulée par ladite boucle d'enlèvement de distorsion, lesdits moyens de détection de synchronisation détectant un niveau de signal ;
des premiers moyens de contrôle (61) fixant la fréquence dudit signal pilote ;
des seconds moyens de contrôle (61) contrôlant ledit premier atténuateur variable et le premier déphaseur variable en se basant sur le niveau de signal de ladite composante de distorsion reçue par lesdits moyens de détection de synchronisation lorsque le signal pilote est entré vers ladite boucle de détection de distorsion en même temps que le signal d'entrée (52, 53 : B) et
des troisièmes moyens de contrôle (61) contrôlant ledit second atténuateur variable et le second déphaseur variable en se basant sur le niveau de signal du signal amplifié dont la distorsion est annulée reçu par lesdits moyens de détection de synchronisation lorsque ledit signal pilote est fourni au chemin de signal dudit amplificateur principal dans ladite boucle de détection de distorsion (52, 53 : A) ; caractérisé en ce que
lesdits premiers moyens de contrôle contrôlent ledit oscillateur à fréquence variable au moyen d'une boucle de rétroaction avec les moyens de détection de synchronisation de sorte que la fréquence du signal pilote soit dans une bande de fréquences désignée au signal d'entrée et autre que les fréquences du signal d'entrée et de la distorsion.

2. Amplificateur d'action anticipée selon la revendication 1, dans lequel lesdits premiers moyens de contrôle contrôlent la fréquence du signal pilote pour qu'elle soit proche d'une valeur moyenne de la fréquence du signal d'entrée.

3. Amplificateur d'action anticipée selon la revendication 1 ou la revendication 2, comprenant, de plus, un capteur d'environnement (64) pour sortir un signal ayant un niveau correspondant à un état de l'environnement détecté et des quatrièmes moyens de contrôle (61) pour suivre le contrôle de ladite boucle d'enlèvement de distorsion par lesdits troisièmes moyens de contrôle dans un état normal après l'exécution du contrôle par lesdits premiers à troisièmes moyens de contrôle et pour exécuter de nouveau le contrôle de ladite boucle de détection de distorsion (412) par lesdits seconds moyens de contrôle lorsqu'il y a un changement du signal de sortie dudit capteur d'environnement dépassant une valeur prédéterminée (409).

4. Amplificateur d'action anticipée selon la revendication 1 ou la revendication 2, comprenant, de plus, des quatrièmes moyens de contrôle (61) pour suivre le contrôle de ladite boucle d'enlèvement de distorsion par lesdits troisièmes moyens de contrôle dans un état normal après l'exécution du contrôle par lesdits premiers à troisièmes moyens de contrôle et pour exécuter de nouveau le contrôle de ladite boucle de détection de distorsion par lesdits seconds moyens de contrôle (412) lorsqu'il y a un changement dans la tension de contrôle fournie à ladite boucle d'enlèvement de distorsion dépassant une valeur prédéterminée (409).

5. Amplificateur d'action anticipée selon la revendication 3 ou 4, dans lequel lesdits quatrièmes moyens de contrôle suivent le contrôle de ladite boucle d'enlèvement de distorsion jusqu'à ce qu'un temps prédéterminé se soit écoulé après la fin du contrôle desdits troisièmes moyens de contrôle et exécutent de nouveau le contrôle de ladite boucle de détection de distorsion par lesdits seconds moyens de contrôle une fois que le temps prédéterminé (410) s'est écoulé.
